# EUROPÄISCHE PATENTSCHRIFT

(11) **EP 0 354 252 B1**
(45) Veröffentlichungstag und Bekanntmachung des Hinweises auf die Patenterteilung: **01.12.1993**
(21) Anmeldenummer: 88112905.0
(22) Anmeldetag: 08.08.1988
(51) Int. Cl.: H04Q 3/52, H03K 17/693

(54) **Breitbandsignal-Koppeleinrichtung**
Coupling device for broad-band signals
Dispositif de couplage pour signaux à large bande

(43) Veröffentlichungstag der Anmeldung: 14.02.1990
(73) Patentinhaber: SIEMENS AKTIENGESELLSCHAFT, 80333 München (DE)
(72) Erfinder: Trumpp, Gerhard, Dipl.-Ing., D-8039 Puchheim (DE); Wolkenhauer, Jan, Dipl.-Ing., D-8000 München 70 (DE)

(56) Entgegenhaltungen:
- EP-A- 0 249 837
- EP-A- 0 262 479
- FR-A- 2 365 263
- PATENT ABSTRACTS OF JAPAN, Band 4, Nr. 170 (E-35)[652], 22. November 1980 & JP-A-55 117 394
- PATENT ABSTRACTS OF JAPAN, Band 8, Nr. 161 (E-257)[1598], 26. Juli 1984 & JP-A-59 61 315

## Beschreibung

Moderne Entwicklungen der Fernmeldetechnik führen zu diensteintegrierenden Nachrichtenübertragungs- u. -vermittlungs-systemen für Schmalband- und Breitband-Kommunikationsdienste, die als Übertragungsmedium im Bereich der Teilnehmeranschlußleitungen Lichtwellenleiter vorsehen, über die sowohl die Schmalbandkommunikationsdienste, wie insbesondere 64-kbit/s-Digital-Telefonie, als auch Breitbandkommunikationsdienste, wie insbesondere 140-Mbit/s-Bildtelefonie, geführt werden, wobei in den Vermittlungsstellen auch (vorzugsweise gemeinsame Steuereinrichtungen aufweisende) Schmalbandsignal-Koppeleinrichtungen und Breitbandsignal-Koppeleinrichtungen nebeneinander vorgesehen sein können (DE-C-24 21 002).

Eine (z.B. aus EP-A1-0 262 479) bekannte Breitbandsignal-Koppeleinrichtung weist eine Koppelpunktmatrix in FET-Technik auf, deren Koppelelemente jeweils mit einem an seiner Steuerelektrode mit einem Durchschalte- bzw. Sperrsignal beaufschlagten, mit einer Hauptelektrode an die zugehörige Matrixausgangsleitung angeschlossenen Schalter-Transistor gebildet sind,
wobei die Koppelelemente jeweils einen mit dem Schalter-Transistor eine Serienschaltung bildenden Vorschalt-Transistor aufweisen, der mit seiner Steuerelektrode an die zugehörige Matrixeingangsleitung angeschlossen ist und dessen der Serienschaltung abgewandte Hauptelektrode über einen Abtast-Transistor mit dem einen Anschluß der Betriebsspannungsquelle verbunden ist, mit deren anderen Anschluß die jeweilige Matrixausgangsleitung über einen Vorlade-Transistor verbunden ist,
und wobei Vorlade-Transistor und Abtast-Transistor gegensinnig zueinander jeweils an ihrer Steuerelektrode mit einem eine Bit-Durchschaltezeitspanne in eine Vorladephase und die eigentliche Durchschaltephase unterteilenden Koppelfeld-Ansteuer-Takt beaufschlagt sind, so daß in jeder Vorphase bei gesperrtem Abtast-Transistor die Matrixausgangsleitung über den Vorlade-Transistor zumindest angenähert auf das an dem genannten anderen Anschluss der Betriebsspannungsquelle herrschende Potential geladen wird.

Diese bekannte Breitbandsignal-Koppeleinrichtung, die koppelelement-individuelle Abtasttransistoren oder matrixeingangsleitungs- oder matrixausgangsleitungs-individuelle Abtast-Transistoren aufweisen kann, benötigt zur Ansteuerung dieser Abtast-Transistoren eigene, die Koppelpunktmatrix durchziehende Taktleitungen, was einen entsprechenden Flächenbedarf erfordert und eine entsprechende kapazitive Belastung der Matrixausgangsleitungen mit sich bringt; Taktverteilung und Kopplungen zwischen Matrixeingangsleitungen und Matrixausgangsleitungen erfordern zur Gewährleistung einer ausreichenden Störsicherheit ausreichend große Signalamplituden auf den Matrixausgangsleitungen, was mit einem relativ hohen Leistungsverbrauch verbunden ist.

Die Erfindung stellt sich nun die Aufgabe, einen Weg zu einer Breitbandsignal-Koppeleinrichtung mit begrenzter Verlustleistung bei hinreichender Störsicherheit aufzuzeigen, in der solche Nachteile vermieden sind.

Die Erfindung betrifft eine Breitbandsignal-Koppeleinrichtung mit einer Koppelpunkt-Matrix in FET-Technik,
deren Eingänge jeweils mit einer Eingangstreiberschaltung versehen sein können,
deren Ausgänge jeweils mit einer Ausgangsverstärkerschaltung versehen sind und
deren jeweils von einer Halte-Speicherzelle gesteuerten Koppelelemente jeweils mit einer **Serienschaltung** eines an seiner Steuerelektrode mit einem Durchschalte- bzw. Sperrsignal beaufschlagten Schalter-Transistors und eines mit seiner Steuerelektrode an die zugehörige Matrixeingangsleitung angeschlossenen Eingangs-Transistors gebildet sind, **die** mit der der Serienschaltung abgewandten Hauptelektrode des einen Transistors an die zugehörige Matrixausgangsleitung angeschlossen ist, wobei die Matrixausgangsleitung über einen Transistor mit dem einen Anschluß der Betriebsspannungsquelle verbunden ist; diese Breitbandsignal-Koppeleinrichtung ist erfindungsgemäß dadurch gekennzeichnet, daß die der Serienschaltung abgewandte Hauptelektrode des anderen Transistors kontinuierlich mit dem anderen Anschluß der Betriebsspannungsquelle verbunden ist und daß die Transistor-Serienschaltung jedes Koppelelements den koppelpunktindividuellen einen Zweig eines Differenzverstärkers bildet, dessen jeweils den zu ein und derselben Ausgangsleitung führenden Koppelpunkten gemeinsamer anderer Zweig durch die eine **Serienschaltung** eines mit seiner Steuerelektrode an dem anderen An schluß der Betriebsspannungsquelle liegenden ersten Transistors und eines an seiner Steuerelektrode mit einer Referenzspannung beaufschlagten zweiten Transistors aufweisende matrixausgangs-leitungs-individuelle Ausgangsverstärkerschaltung gebildet ist, **die** mit der der Serienschaltung abgewandten Hauptelektrode des einen Transistors an die zugehörige Matrixausgangs-leitung angeschlossen ist und **deren** der Serienschaltung abgewandte, zum Verstärkerausgang führende Hauptelektrode des anderen Transistors über einen Lasttransistor mit dem genannten anderen Anschluß der Betriebsspannungsquelle verbunden ist.

Die Erfindung bringt neben dem Vorteil, daß die Koppeleinrichtung weder für etwaige Eingangstreiberschaltungen noch für die Koppelpunktmatrix selbst noch für die Ausgangsverstärkerschaltungen einen Takt und somit entsprechende Taktleitungen benötigt und daß damit auch die gesamte Bit-Durchschaltezeitspanne, unverkürzt durch eine Vorladephase, für das Durchschalten des jeweiligen Bits zur Verfügung steht, den weiteren Vorteil mit sich, daß die Eingangsleitung mit sehr kleinem Signalhub von z.B. 1 V bei einer Betriebsspannung von z.B. 5 V betrieben werden kann, was eine entsprechende Reduzierung der Signalkopplungen von den Matrixeingangsleitungen auf die Matrixausgangsleitungen und damit eine Reduzierung der aufzuwendenden Verlustleistungen mit sich bringt; zugleich bringt die mögliche Signalhubreduzierung auf der Matrixeingangsleitung ebenso wie der Wegfall einer Vorladephase auch eine Reduzierung von durch Stromspitzen bedingten Störungen der Betriebsspannung der Breitbandsignal-Koppeleinrichtung mit sich. Im übrigen weist der gemäß der Erfindung vorgesehene "verteilte" Differenzverstärker auch die bekannten Vorzüge herkömmlicher Differenzverstärker auf.

In weiterer Ausgestaltung der Erfindung kann die Transistor-Serienschaltung jedes Koppelelements mit ihrem Eingangs-Transistor und die Transistor-Serienschaltung des jeweiligen Ausgangsverstärkers mit dem genannten zweiten Transistor an der Matrixausgangsleitung liegen.
Alternativ dazu ist es aber möglich, daß in weiterer Ausgestaltung der Erfindung die Transistor-Serienschaltung jedes Koppelelements mit ihrem Schalter-Transistor und die Transistor-Serienschaltung des jeweiligen Ausgangsverstärkers mit dem genannten ersten Transistor an der Matrixausgangsleitung liegt, was eine kapazitive Belastung der Matrixausgangsleitung durch die Kanalkapazität der Vorschalt-Transistoren nichtdurchgeschalteter Koppelelemente vermeidet.

Die Transistor-Serienschaltung jedes Koppelelements kann in weiterer Ausgestaltung der Erfindung mit dem genannten anderen Anschluß der Betriebsspannungsquelle über einen Lasttransistor verbunden sein, was eine entsprechende Symmetrie beider Zweige des jeweils gebildeten Differenzverstärkers mit sich bringt.

Weitere Besonderheiten der Erfindung werden aus der nachfolgenden näheren Erläuterung der Erfindung anhand der Zeichnung ersichtlich. Dabei zeigen
FIG 1 das Schema einer Breitband-Koppeleinrichtung und
FIG 2 bis FIG 8 Einzelheiten ihrer schaltungstechnischen Realisierung gemäß der Erfindung.

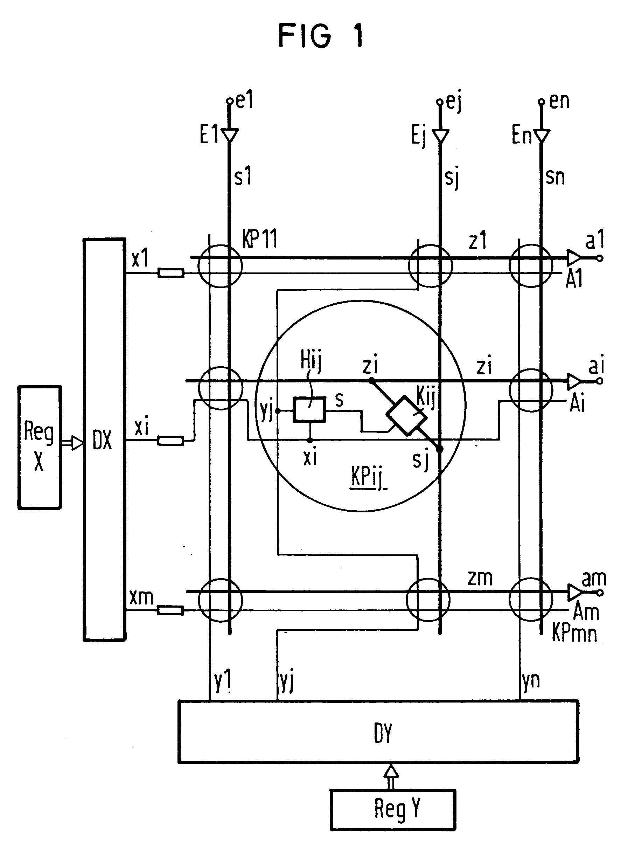

In der Zeichnung FIG 1 ist schematisch in zum Verständnis der Erfindung erforderlichem Umfange eine Breitbandsignal-Koppeleinrichtung skizziert, an deren zu Spaltenleitungen sl...sj...sn einer Koppelpunktmatrix führenden Eingängen el...ej...en Eingangstreiberschaltungen El...Ej...En vorgesehen sind und deren von Zeilenleitungen zl...zi...zm der Koppelpunktmatrix erreichte Ausgänge al...ai...am mit Ausgangsverstärkerschaltungen Al...Ai...Am versehen sind.
Die Koppelpunktmatrix weist Koppelpunkte KPll...KPij...KPmn auf, deren Koppelelemente, wie dies beim Koppelpunkt KPij für dessen Koppelelement Kij weiter ins Einzelne gehend angedeutet ist, jeweils von einer koppelpunktindividuellen Halte-Speicherzelle Hij (beim Koppelpunkt KPij) gesteuert sein können, deren Ausgang s zum Steuereingang des jeweiligen Koppelelements (Kij beim Koppelpunkt KPij) führt.

Die Halte-Speicherzellen ... Hij... werden gemäß FIG 1 durch zwei Ansteuerdecoder, nämlich einen Zeilendecoder DX und einen Spaltendecoder DY, über entsprechende Ansteuerleitungen xl...xi...xm; yl...yj...yn in zwei Koordinaten angesteuert.

Dazu mögen, wie dies aus FIG 1 ersichtlich ist, die beiden Ansteuerdecoder DX, DY von Eingangsregistern Reg X, Reg Y her jeweils mit einer einer Matrixreihe (Zeile bzw.Spalte) von Koppelpunkten gemeinsamen Koppelpunktzeilen- bzw. Koppelpunktspalten-Adresse beaufschlagbar sein, auf die hin sie jeweils an der der jeweiligen Koppelpunktreihen-Adresse entsprechenden Ansteuerleitung jeweils ein "1"-Ansteuersignal abgeben. Das Zusammentreffen eines Zeilenansteuersignals "1" und eines Spaltenansteuersignals "1" am Kreuzungspunkt der betreffenden Matrixzeile mit der betreffenden Matrixspalte beim Aufbau einer entsprechenden Verbindung bewirkt dann eine Aktivierung der dort befindlichen Halte-Speicherzelle, beispielsweise der Speicherzelle Hij, mit der Folge, daß das von der betreffenden Halte-Speicherzelle (Hij) gesteuerte Koppelelement, im Beispiel das Koppelelement Kij, leitend wird.

Damit das im Beispiel betrachtete Koppelelement Kij bei einem Abbau der betreffenden Verbindung wieder gesperrt wird, wird wiederum der Ansteuerdecoder DX vom Eingangsregister Reg X mit der betreffenden Zeilenadresse beaufschlagt, so daß der Zeilendecoder DX wiederum auf seiner Ausgangsleitung xi ein Zeilenansteuersignal "1" abgibt, und zugleich wird der Spaltendecoder DY von seinem Eingangsregister Reg Y her beispielsweise mit einer Leeradresse oder mit der Adresse einer Spalte von unbeschalteten Koppelpunkten beaufschlagt, so daß er auf seiner Ausgangsleitung yj ein Spaltenansteuersignal "0" abgibt; das Zusammentreffen von Zeilenansteuersignal "1" und Spaltenansteuersignal "0" bewirkt dann die Rücksetzung der Halte-Speicherzelle Hij mit der Folge, daß das von ihr gesteuerte Koppelelement Kij gesperrt wird.

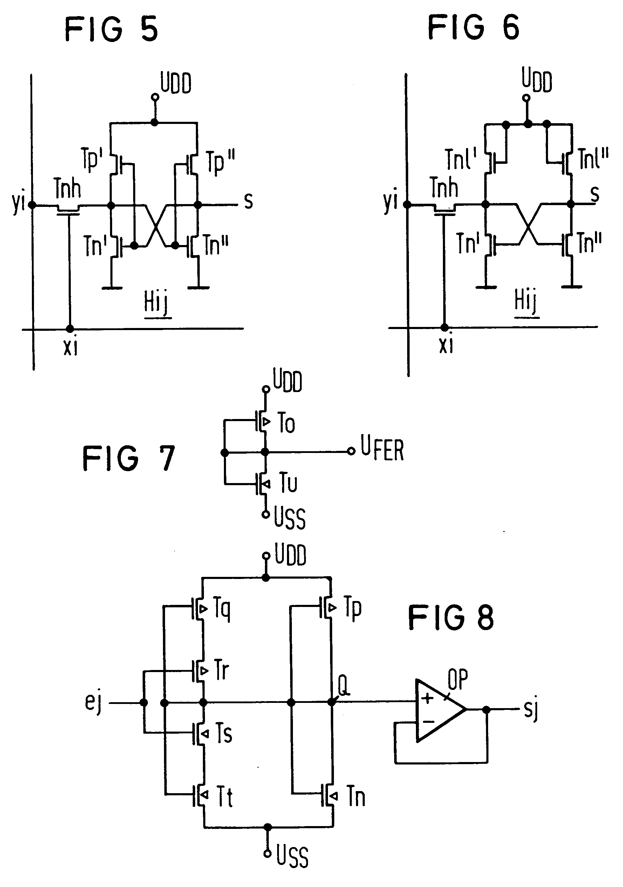

Die Halte-Speicherzellen ...Hij... können in an sich bekannter Weise ausgebildet sein; so können die Halte-Speicherzellen beispielsweise, wie dies z.B. aus EP-A-0 238 834 bekannt und auch in FIG 5 und FIG 6 skizziert ist, mit einem n-Kanal-Transistor Tnh und zwei kreuzgekoppelten Inverterschaltungen (C-MOS-Inverterschaltungen Tp′,Tn′; Tp'',Tn'' in FIG 5, n-MOS-Inverterschaltungen Tnl′,Tn′; Tnl'',Tn'' in FIG 6) gebildet sein, wobei eine Inverterschaltung eingangsseitig mit dem zugehörigen Decoderausgang yj des einen Ansteuerdecoders über den n-Kanal-Transistor Tnh verbunden ist, der seinerseits an seiner Steuerelektrode mit dem Ausgangssignal des zugehörigen Decoderausgangs xi des anderen Ansteuerdecoders beaufschlagt ist, und wobei eine Inverterschaltung ausgangsseitig zum Steuereingang s des zugehörigen Koppelelements führt.

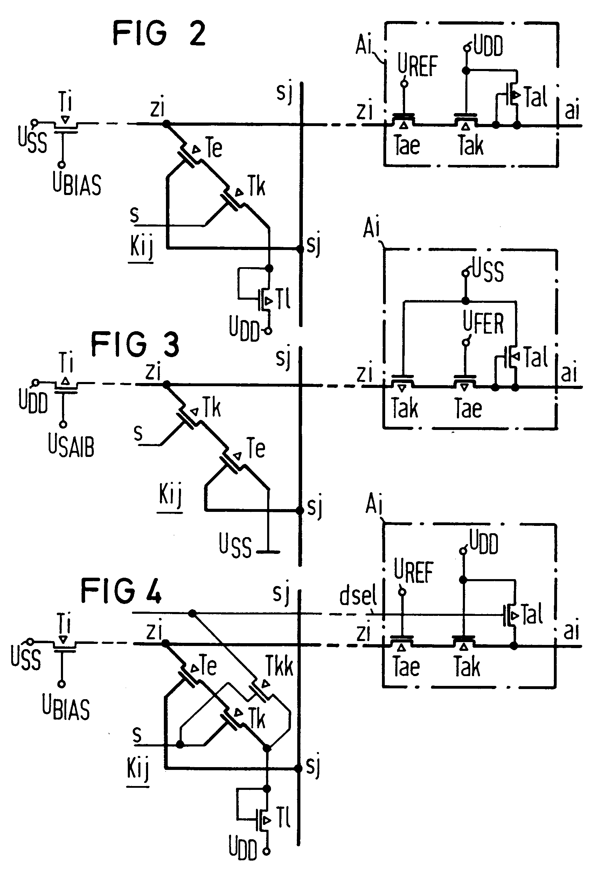

Wie die Koppelelemente ...Kij... schaltungstechnisch realisiert sein können, wird in FIG 2, FIG 3 und FIG 4 verdeutlicht: Die Koppelelemente ...Kij... sind jeweils mit einer **Serienschaltung** eines an seiner Steuerelektrode von der Halte-Speicherzelle her mit einem Durchschalte- bzw. Sperrsignal beaufschlagten Schalter-Transistors Tk und eines mit seiner Steuerelektrode an die zugehörige Matrixeingangsleitung sj angeschlossenen Eingangs-Transistors Te gebildet, **die** mit der der Serienschaltung abgewandten Hauptelektrode des einen Transistors Tk (in FIG 3) oder Te (in FIG 2 und FIG 4) an die zugehörige Matrixausgangsleitung zi angeschlossen ist, wobei die Matrixausgangsleitung zi mit dem einen Anschluß (U_{DD} in FIG 3; U_{SS} in FIG 2 und FIG 4) der Betriebsspannungsquelle U_{DD}-U_{SS} über einen mit seiner Steuerelektrode an einer entsprechenden Vorspannung (U_{SAIB} in FIG 3; U_{BIAS} in FIG 2 und FIG 4) liegenden Transistor Ti verbunden ist, der zusammen mit der Betriebsspannungsquelle eine Stromquelle bildet. Die der Serienschaltung abgewandte Hauptelektrode des anderen Transistors Te (in FIG 3) bzw. Tk (in FIG 2 und FIG 4) ist fest mit dem anderen Anschluß U_{SS}, Masse (in FIG 3) bzw. U_{DD}(in FIG 2, FIG 4) der Betriebsspannungsquelle verbunden. Dabei bildet die Transistor-Serienschaltung Tk-Te jedes Koppelelements Kij den koppelpunkt-individuellen einen Zweig eines Differenzverstärkers, dessen jeweils anderer Zweig durch die jeweilige matrixausgangsleitungs-individuelle Ausgangsverstärkerschaltung Ai gebildet und somit den zu ein und derselben Ausgangsleitung zi führenden Koppelpunkten gemeinsam ist. Die Ausgangsverstärkerschaltung Ai weist dazu eine **Serienschaltung** eines mit seiner Steuerelektrode an dem genannten anderen Anschluß (U_{SS}, Masse in FIG 3; U_{DD} in FIG 2 und FIG 4) der Betriebsspannungsquelle liegenden ersten Transistors Tak und eines an seiner Steuerelektrode mit einer Referenzspannung (U_{FER} in FIG 3; U_{REF} in FIG 2 und FIG 4) beaufschlagten zweiten Transistors Tae auf, **die** mit der der Serienschaltung abgewandten Hauptelektrode des einen Transistors Tak (in FIG 3) oder Tae (in FIG 2 und FIG 4) an die zugehörige Matrixausgangsleitung zi angeschlossen ist und **deren** der Serienschaltung abgewandte, zum Verstärkerausgang ai führende Hauptelektrode des anderen Transistors Tae (in FIG 3) bzw. Tak (in FIG 2 und FIG 4) über einen gegebenenfalls als Diode geschalteten Lasttransistor Tal mit dem genannten anderen Anschluß (U_{SS}, Masse in FIG 3; U_{DD} in FIG 2 und FIG 4) der Betriebsspannungsquelle verbunden ist.

Dabei kann, wie dies - im Unterschied zu FIG 3 - FIG 2 und FIG 4 verdeutlichen, die Transistor-Serienschaltung Tk-Te jedes Koppelelements Kij mit dem genannten anderen Anschluß (U_{SS}, Masse in FIG 3; U_{DD} in FIG 2 und FIG 4) der Betriebsspannungsquelle über einen als Diode geschalteten Lasttransistor Tl verbunden sein. Ein solcher Lasttransistor gewährleistet eine entsprechend hohe Symmetrie des jeweils durch Koppelelement Kij und Ausgangsverstärker Ai gebildeten Differenzverstärkers, ist indessen mit einem entsprechenden Flächenbedarf verbunden. Dieser Flächenbedarf entfällt bei einem mit einer leichten Unsymmetrie des Differenzverstärkers verbundenen und deshalb einen geringfügig höheren Signalhub erfordernden Verzicht auf den koppelpunkt-individuellen Lasttransistor Tl (in FIG 2 und FIG 4).

Wie dies aus FIG 2 und FIG 4 ersichtlich ist, kann die Transistor-Serienschaltung Tk-Te jedes Koppelelements Kij mit ihrem Eingangs-Transistor Te an der Matrixausgangsleitung zi liegen; in entsprechender Weise liegt dann die Transistor-Serienschaltung Tak-Tae des matrixausgangsleitungs-individuellen Ausgangsverstärkers Ai mit dem genannten zweiten Transistor Tae an der Matrixausgangsleitung zi. Dabei ist der Eingangs-Transistor Te, von der Matrixausgangsleitung zi her gesehen, gewissermaßen transparent, so daß Signalzustandsänderungen auf der Matrixeingangsleitung sj über die Kanalkapazität des Eingangs-Transistors Te auch bei gesperrtem Koppelpunkt Kij auf die Matrixausgangsleitung zi durchgreifen.

Dieser Durchgriff kann vermieden werden, wenn man in der Transistor-Serienschaltung Tk-Te jedes Koppelelements Kij die Reihenfolge von Eingangs-Transistor Te und Schalter-Transistor Tk vertauscht: Wie dies auch aus FIG 3 ersichtlich ist, liegt dann die Transistor-Serienschaltung Tk-Te jedes Koppelelements Kij mit ihrem Schalter-Tranistor Tk an der Matrixausgangsleitung zi, und in entsprechender Weise liegt dann die Transistor-Serienschaltung Tak-Tae des zugehörigen, matrixausgangsleitungs-individuellen Ausgangsverstärkers Ai mit dem genannten ersten Transistor Tak an der Matrixausgangsleitung zi.

Gemäß dem in FIG 4 skizzierten Ausführungsbeispiel ist neben jeder Matrixausgangsleitung (zi) eine zur Steuerelektrode des Ausgangsverstärker-Lasttransistors (Tal) führenden Signalleitung dsel vorgesehen, mit der der Lasttransistor (Tl) jedes an der betreffenden Matrixausgangsleitung (zi) liegenden Koppelelements (Kij) über einen Zusatz-Transistor Tkk verbunden ist, der ebenso wie der Schalter-Transistor Tk des betreffenden Koppelelements (Kij) an dessen Steuereingang s angeschlossen ist. Hierdurch wird mit einer Stromspiegelung vom Koppelelement-Zweig auf den Ausgangsverstärker-Zweig des jeweils von einem Koppelelement (Kij) und der matrixausgangsleitungs-individuellen Ausgangsverstärkerschaltung Ai gebildeten Differenzverstärkers eine differential-to-single-ended-Umsetzung der über das betreffende Koppelelement durchgeschalteten Digitalsignale erreicht, was eine Signalverstärkung von 6 dB mit sich bringt, aber auch mit entsprechendem Platz- und Leistungsbedarf verbunden ist.

Wie FIG 2 bis FIG 4 zeigen, sind in dem jeweils durch ein Koppelelement (Kij) und eine Ausgangsverstärkerschaltung (Ai) gebildeten, gewissermaßen "verteilten" Differenzverstärker die Transistoren Te, Tae, Ti von zum Typ des jeweiligen Lasttransistors Tal und ggf. Tl komplementärem Typ.
So sind gemäß FIG 2 und FIG 4 die Lasttransistoren Tal und Tl vom p-Kanal-Typ, während Ausgangsverstärker-Transistoren Tae und Tak, Stromquellen-Transistor Ti und Eingangs-Transistor Te des jeweiligen Koppelelements (Kij) - und im Ausführungsbeispiel auch der jeweilige Schalter-Transistor Tk - vom n-Kanal-Typ sind. Die Betriebsspannungsquelle U_{DD}-U_{SS} möge dabei eine für C-MOS-Schaltungen übliche Betriebsspannung von z.B. 5 V abgeben, aus der jeweils mit Hilfe einer entsprechend dimensionierte Transistoren To, Tu aufweisenden Spannungsteilerschaltung in Form einer in sich rückgekoppelten Inverterschaltung, wie sie in FIG 7 skizziert ist, auch eine Referenzsspannung U_{REF} von z.B. 2 V bzw. eine die Schwellwertspannung des Stromquellen-Transistors Ti von z.B. 1,2 V leicht überschreitende Vorspannung U_{BIAS} von z.B. 1,5 V abgeleitet sein kann.
Gemäß FIG 3 ist der Ausgangsverstärker-Lasttransistor Tal vom n-Kanal-Typ, während die Ausgangsverstärker-Transistoren Tae und Tak, Stromquellen-Transistor Ti und Eingangs-Transistor Te des jeweiligen Koppelelements (Kij) - und im Ausführungsbeispiel auch der jeweilige Schalter-Transistor Tk - vom p-Kanal-Typ sind. Die Betriebsspannungsquelle U_{DD}-U_{SS} möge wiederum eine für C-MOS-Systeme übliche Betriebsspannung von z.B. 5 V abgeben, aus der dann wiederum jeweils mit Hilfe einer Spannungsteilerschaltung, wie sie in FIG 7 skizziert ist, eine Referenzspannung U_{FER} von z.B. 3 V bzw. eine Stromquellen-Transistor-Vorspannung U_{SAIB} von z.B. 3,5 V abgeleitet werden kann.

Um die einzelnen Koppelzellen ...Kij... möglichst klein halten zu können, wird die Verstärkung des "verteilten" Differenzverstärkers relativ gering gehalten. Für eine etwa erforderliche weitere Verstärkung des Ausgangssignals kann dann der matrixausgangsleitungs-individuellen Ausgangsverstärkerschaltung Ai beispielsweise eine pseudo-p-MOS- bzw. -n-MOS-Verstärkerstufe nachgeschaltet sein, was indessen in den Zeichnung nicht mehr dargestellt ist, da dies zum Verständnis der Erfindung nicht erforderlich ist.

Wie oben bereits erwähnt wurde, kann die Referenzspannungsquelle für den Ausgangsverstärker-Transistor Tae durch einen als an der Betriebsspannungsquelle U_{DD}-U_{SS} liegender Spannungsteiler betriebenen, in sich rückgekoppelten Inverter gebildet sein. Eine solche mit einem p-Kanal-Transistor To und einem n-Kanal-Transistor Tu realisierte C-MOS-Inverter-Spannungsteilerschaltung ist in FIG 7 dargestellt. Die am Ausgang U_{FER} dieses als Spannungsteiler betriebenen C-MOS-Inverters auftretende Referenzspannung ist dabei durch die Abmessung der beiden Transistoren To und Tu festgelegt.

Die gleichen Transistorabmessungen können auch die jeweils beiden Transistoren von in sich rückgekoppelten C-MOS-Invertern Tp-Tn (in FIG 8) aufweisen, die jeweils zusammen mit einer weiteren rückgekoppelten C-MOS-Inverterschaltung Tq-Tr-Ts-Tt (in FIG 8), mit dieser jeweils eine Ringschaltung bildend, an den Eingängen ...ej... der Breitbandsignal-Koppeleinrichtung vorgesehene Eingangstreiberschaltungen ...Ej... bilden. Ringschaltungen zweier in sich rückgekoppelter C-MOS-Inverter sind an sich (aus der EP-A- 0 250 933) bekannt. In dem in FIG 8 skizzierten Ausführungsbeispiel weist dabei die genannte weitere C-MOS-Inverterschaltung in ihren beiden Schaltungszweigen jeweils eine Serienschaltung zweier Transistoren Tq-Tr bzw. Ts-Tt auf, deren jeweils innerer Transistor Tr bzw. Ts an seiner Steuerelektrode mit dem Eingang ej der Breitbandsignal-Koppeleinrichtung verbunden ist.

Die Schaltschwelle des C-MOS-Inverters Tp-Tn ist durch die geometrischen Abmessungen seines an der einen Klemme U_{DD} der Betriebsspannungsquelle liegenden p-Kanal-Transistors Tp und seines an der anderen Klemme U_{SS} der Betriebsspannungsquelle liegenden n-Kanal-Transistors Tn gegeben; sie liegt bei Übereinstimmung dieser Abmessungen mit denen der beiden entsprechenden Transistoren (To und Tu) einer gemäß FIG 7 als C-MOS-Inverter-Spannungsteilerschaltung ausgebildeten Referenzspannungsquelle bei der von dieser abgegebenen Referenzspannung. Dies hat zur Folge, daß auch bei Schwankungen der Betriebsspannung U_{DD}-U_{SS} oder auch bei Änderung von technologischen Parametern der HIGH-Pegel und der LOW-Pegel eines vom Koppeleinrichtungseingang ej her über die Breitbandsignal-Koppeleinrichtung durchgeschalteten Digitalsignals relativ zum Pegel der in der Ausgangsverstärkerschaltung Ai (in FIG 2 bis FiG 4) wirksamen Referenzspannung U_{REF} (in FIG 2 und FIG 4) bzw. U_{FER} (in FIG 3 und FIG 7) in weiten Grenzen konstant bleiben.
Dabei wird die jeweilige Pegelhöhe mit durch die geometrischen Abmessungen des an der Klemme U_{DD} der Betriebsspannungsquelle liegenden p-Kanal-Transistors Tq und des an der Klemme U_{SS} der Betriebsspannungsquelle U_{SS} liegenden n-Kanal-Transistors Tt der genannten weiteren C-MOS-Inverterschaltung bestimmt: Bei am Koppelfeldeingang ej auftretendem LOW-Signal ist über den demzufolge leitenden p-Kanal-Transistor Tr der p-Kanal-Transistor Tq der genannten weiteren C-MOS-Inverterschaltung Tq-Tr-Ts-Tt dem p-Kanal-Transistor Tp des in sich rückgekoppelten C-MOS-Inverters Tp-Tn parallelgeschaltet, und bei am Koppelfeldeingang ej auftretendem HIGH-Signal ist über den demzufolge leitenden n-Kanal-Transistor Ts der n-Kanal-Transistor Tt der genannten weiteren C-MOS-Inverterschaltung Tq-Tr-Ts-Tt dem n-Kanal-Transistor Tn des in sich rückgekoppelten C-MOS-Inverters Tp-Tn parallelgeschaltet. Diese Parallelschaltung verändert das jeweils am Schaltungspunkt Q wirksame Spannungsteilerverhältnis, so daß bei vollem C-MOS-Signalhub von z.B. 5 V der am Koppelfeldeingang ej (in FIG 1 und FIG 8) auftretenden Digitalsignale die am Ausgang der Eingangstreiberschaltung Ej (in FIG 1 und FIG 8) und damit auf der zugehörigen Matrixeingangsleitung sj (in FIG 1 und FIG 8) auftretenden Digitalsignale in ihrem Signalhub auf einen Wert von z.B. 1 V reduziert werden. Dabei können, wie dies auch aus FIG 8 ersichtlich ist, diese Digitalsignale mittels eines als Spannungsfolger geschalteten Differenzverstärkers OP gepuffert sein.

## Patentansprüche

1. Breitbandsignal-Koppeleinrichtung mit einer Koppelpunkt-Matrix in FET-Technik,
deren Eingänge (ej-sj) jeweils mit einer Eingangstreiberschaltung (Ej) versehen sein können,
deren Ausgänge (zi-ai) jeweils mit einer Ausgangsverstärkerschaltung versehen sind und
deren jeweils von einer Halte-Speicherzelle (Hij) gesteuerte Koppelelemente (Kij) jeweils mit einer **Serienschaltung** eines an seiner Steuerelektrode mit einem Durchschalte- bzw. Sperrsignal beaufschlagten Schalter-Transistors (Tk) und eines mit seiner Steuerelektrode an die zugehörige Matrixeingangsleitung (sj) angeschlossenen Eingangs-Transistors (Te) gebildet sind, **die** mit der der Serienschaltung abgewandten Hauptelektrode des einen Transistors (Tk oder Te) an die zugehörige Matrixausgangsleitung (zi) angeschlossen ist, wobei die Matrixausgangsleitung (zi) über einen Transistor (Ti) mit dem einen Anschluß (U_{DD}) der Betriebsspannungsquelle verbunden ist,
**dadurch gekennzeichnet,**
daß die der Serienschaltung abgewandte Hauptelektrode des anderen Transistors (Te oder Tk) fest mit dem anderen Anschluß (U_{SS}, Masse) der Betriebsspannungsquelle verbunden ist und
daß die Transistor-Serienschaltung (Tk-Te) jedes Koppelelements (Kij) den koppelpunkt-individuellen einen Zweig eines Differenzverstärkers bildet, dessen jeweils den zu ein und derselben Ausgangsleitung (zi) führenden Koppelpunkten (KPij) gemeinsamer anderer Zweig durch die eine **Serienschaltung** eines mit seiner Steuerelektrode an dem anderen Anschluß (U_{SS}, Masse) der Betriebsspannungsquelle liegenden ersten Transistors (Tak) und eines an seiner Steuerelektrode mit einer Referenzspannung (U_{FER}) beaufschlagten zweiten Transistors (Tae) aufweisende matrixausgangsleitungs-individuelle Ausgangsverstärkerschaltung (Ai) gebildet ist, **die** mit der der Serienschaltung abgewandten Hauptelektrode des einen Transistors (Tak oder Tae) an die zugehörige Matrixausgangsleitung (zi) angeschlossen ist und **deren** der Serienschaltung abgewandte, zum Verstärkerausgang (ai) führende Hauptelektrode des anderen Transistors (Tae oder Tak) über einen Lasttransistor (Ta) mit dem genannten anderen Anschluß (U_{SS}, Masse) der Betriebsspannungsquelle verbunden ist.

2. Breitbandsignal-Koppeleinrichtung nach Anspruch 1,
**dadurch gekennzeichnet,**
daß die Transistor-Serienschaltung (Tk-Te) jedes Koppelelements (Kij) mit dem genannten anderen Anschluß (U_{SS}, Masse) der Betriebs-spannungsquelle über einen Lasttransistor (Tl) verbunden ist.

3. Breitbandsignal-Koppeleinrichtung nach Anspruch 1 oder 2,
**dadurch gekennzeichnet,**
daß die Transistor-Serienschaltung (Tk-Te) jedes Koppelelements (Kij) mit ihrem Schalter-Transistor (Tk) und die Transistor-Serienschaltung (Tak-Tae) des jeweiligen Ausgangsverstärkers (Ai) mit dem genannten ersten Transistor (Tak) an der Matrixausgangsleitung (zi) liegt.

4. Breitbandsignal-Koppeleinrichtung nach Anspruch 1 oder 2,
**dadurch gekennzeichnet,**
daß die Transistor-Serienschaltung (Tk-Te) jedes Koppelelements (Kij) mit ihrem Eingangs-Transistor (Te) und die Transistor-Serienschaltung (Tak-Tae) des jeweiligen Ausgangsverstärkers (Ai) mit dem genannten zweiten Transistor (Tae) an der Matrixausgangsleitung (zi) liegt.

5. Breitbandsignal-Koppeleinrichtung nach einem der Ansprüche 1 bis 4,
**dadurch gekennzeichnet,**
daß als Referenzspannungsquelle (U_{FER}) ein in sich rückgekoppelter C-MOS-Inverter (To, Tu) vorgesehen ist.

6. Breitbandsignal-Koppeleinrichtung nach Anspruch 5,
**dadurch gekennzeichnet,**
daß den Matrixeingangsleitungen (sj) vorgeschaltete Eingangstreiberschaltungen (Ej) jeweils mit einem in sich rückgekoppelten C-MOS-Inverter (Tp, Tn) mit den gleichen Transistorabmessungen gebildet ist, der mit einer weiteren in sich rückgekoppelten C-MOS-Inverterschaltung (Tq, Tr, Ts, Tt) eine Ringschaltung bildet, wobei diese weitere C-MOS-Inverterschaltung in ihren beiden Schaltungszweigen jeweils eine Serienschaltung zweier Transistoren (Tq, Tr; Ts, Tt) aufweist, deren jeweils innerer Transistor (Tr; Ts) an seiner Steuerelektrode mit dem Eingang (ej) der Breitbandsignal-Koppeleinrichtung verbunden ist.

7. Breitbandsignal-Koppeleinrichtung nach Anspruch 6,
**dadurch gekennzeichnet,**
daß dem C-MOS-Inverter (Tp, Tn) ein als Spannungsfolger geschalteter Differenzverstärker (OP) nachgeschaltet ist.

## Claims

1. Broadband signal switching network having a crosspoint matrix in FET technology,
the inputs (ej-sj) of which can each be provided with an input driver circuit (Ej),
the outputs (zi-ai) of which are each provided with an output amplifier circuit (Ai), and
the switching elements (Kij) of which, controlled by a holding memory cell (Hij) in each case, are each formed by a series circuit of a switching transistor (Tk) whose control electrode receives a through-connect signal or inhibit signal and an input transistor (Te) that is connected by its control electrode to the associated matrix input line (sj), which series circuit is connected to the associated matrix output line (zi) by the main electrode of the one transistor (Tk or Te) remote from the series circuit,
in which the matrix output line (zi) is connected to one terminal (U_{DD}) of the operating voltage source via a transistor (Ti),
characterized in that the main electrode of the other transistor (Te or Tk) remote from the series circuit is permanently connected to the other terminal (U_{SS}, ground) of the operating voltage source, and in that the transistor series circuit (Tk-Te) of each switching element (Kij) forms one crosspoint-specific branch of a differential amplifier, whose other branch that is shared in each case by the crosspoints (KPij) leading to one and the same output line (zi) is formed by the output amplifier circuit (Ai) individually associated with the matrix output line, which output amplifier circuit has a series circuit of a first transistor (Tak) which is connected by its control electrode to the other terminal (U_{SS}, ground) of the operating voltage source and a second transistor (Tae) which receives a reference voltage (U_{FER}) at its control electrode, which series circuit is connected by the main electrode of the one transistor (Tak or Tae) remote from the series circuit to the associated matrix output line (zi), and whose main electrode of the other transistor (Tae or Tak) remote from the series circuit and leading to the amplifier output (ai) is connected via a load transistor (Ta) to the aforesaid other terminal (U_{SS}, ground) of the operating voltage source.

2. Broadband signal switching network according to Claim 1, characterized in that the transistor series circuit (Tk-Te) of each switching element (Kij) is connected via a load transistor (Tl) to the aforesaid other terminal (U_{SS}, ground) of the operating voltage source.

3. Broadband signal switching network according to Claim 1 or 2, characterized in that the transistor series circuit (Tk-Te) of each switching element (Kij) is connected by its switching transistor (Tk) and the transistor series circuit (Tak-Tae) of the respective output amplifier (Ai) is connected by the aforesaid first transistor (Tak) to the matrix output line (zi).

4. Broadband signal switching network according to Claim 1 or 2, characterized in that the transistor series circuit (Tk-Te) of each switching element (Kij) is connected by its input transistor (Te) and the transistor series circuit (Tak-Tae) of the respective output amplifier (Ai) is connected by the aforesaid second transistor (Tae) to the matrix output line (zi).

5. Broadband signal switching network according to one of Claims 1 to 4, characterized in that a feedback C-MOS inverter (To, Tu) is provided as reference voltage source (U_{FER}).

6. Broadband signal switching network according to Claim 5, characterized in that each of the input driver circuits (Ej) connected upstream of the matrix input lines (sj) is formed by a feedback C-MOS inverter (Tp, Tn) having the same transistor dimensions, which forms a ring circuit with a further feedback C-MOS inverter circuit (Tq, Tr, Ts, Tt), said further C-MOS inverter circuit having in its two circuit branches in each case one series circuit of two transistors (Tq, Tr; Ts, Tt), the inner transistor (Tr; Ts) of which is connected in each case by its control electrode to the input (ej) of the broadband signal switching network.

7. Broadband signal switching network according to Claim 6, characterized in that a differential amplifier (OP) connected as voltage follower is connected downstream of the C-MOS inverter (Tp, Tn).

## Revendications

1. Dispositif de couplage de signaux à large bande, comportant une matrice de points de couplage en technique FET,
dont les entrées (ej-sj) peuvent être munies respectivement d'un circuit d'attaque d'entrée (Ej),
dont les sorties (zi-ai) sont munies d'un circuit amplificateur de sortie et
dont les éléments de couplage (Kij), commandés respectivement par une cellule mémoire (Hij) de maintien, sont formés par un circuit série constitué d'un transistor de commutation (Tk) qui est chargé, au niveau de son électrode de commande, par un signal de connexion ou de blocage, et d'un transistor d'entrée (Te) qui est relié, par son électrode de commande, à la ligne d'entrée de matrice (sj) associée, le circuit série étant relié à la ligne de sortie de matrice (zi) associée par l'électrode principale, opposée au circuit série, de l'un des transistors (Tk ou Te),
la ligne de sortie de matrice (zi) étant reliée à l'une des bornes (U_{DD}) de la source de tension de service, par l'intermédiaire d'un transistor (Ti),
caractérisé en ce que
l'électrode principale, opposée au circuit série, de l'autre transistor (Te ou Tk) est reliée de manière fixe à l'autre borne (U_{SS}, Masse) de la source de tension de service et que le circuit série à transistors (Tk-Te) de chaque élément de couplage (Kij) forme l'une des branches, qui est propre aux points de couplage, d'un amplificateur différentiel, dont l'autre voie, commune aux points de couplage (KPij) allant vers une seule et même ligne de sortie (zi), est formée par le circuit amplificateur de sortie (Ai) qui est propre à la ligne de sortie de matrice et qui comporte un circuit série constitué d'un premier transistor (Tak) placé, par son électrode de commande, à l'autre borne (U_{SS}, Masse) de la source de tension de service, et d'un deuxième transistor (Tae) chargé, au niveau de son électrode de commande, par une tension de référence (U_{FER}), ledit circuit série étant relié à la ligne de sortie de la matrice associée (zi), par l'électrode principale, opposée au circuit série, de l'un des transistors (Tak ou Tae), et l'électrode principale de l'autre transistor (Tae ou Tak), opposée audit circuit série et allant vers la sortie (ai) de l'amplificateur, étant reliée, par l'intermédiaire d'un transistor de charge (Ta), à ladite autre borne (U_{SS}, Masse) de la source de tension de service.

2. Dispositif de couplage de signaux à large bande suivant la revendication 1,
caractérisé en ce que
le circuit série à transistors (Tk-Te) de chaque élément de couplage (Kij) est relié, par l'intermédiaire d'un transistor de charge (T1), à ladite autre borne (U_{SS}, Masse) de la source de tension de service.

3. Dispositif de couplage de signaux à large bande suivant la revendication 1 ou 2,
caractérisé en ce que
le circuit série à transistors (Tk-Te) de chaque élément de couplage (Kij) est relié, par son transistor de commutation (Tk) à la ligne de sortie de la matrice (zi) et le circuit série à transistors (Tak-Tae) de l'amplificateur de sortie respectif (Ai) est relié, par ledit premier transistor (Tak), à la ligne de sortie de matrice (zi).

4. Dispositif de couplage de signaux à large bande suivant la revendication 1 ou 2,
caractérisé en ce que
le circuit série à transistors (Tk-Te) de chaque élément de couplage (Kij) est relié à la ligne de sortie de matrice (zi), par son transistor d'entrée (Te), et le circuit série à transistors (Tak-Tae) de l'amplificateur de sortie respectif (Ai) est relié à la ligne de sortie de la matrice (zi), par ledit deuxième transistor (Tae).

5. Dispositif de couplage de signaux à large bande suivant l'une des revendications 1 à 4,
caractérisé en ce
qu'il est prévu, en tant que source de tension de référence (U_{FER}), un inverseur C-MOS (To, Tu) contre-réactionné.

6. Dispositif de couplage de signaux à large bande suivant la revendication 5,
caractérisé en ce que
des circuits d'attaque d'entrée (Ej), montés en amont des lignes d'entrée de la matrice (sj), sont formés respectivement par un inverseur C-MOS (Tp, Tn) qui est contre-réactionné, qui comporte des transistors de mêmes dimensions et qui forme, avec un autre circuit inverseur C-MOS (Tq, Tr, Ts, Tt) contre-réactionné, un circuit en anneau du type dans lequel cet autre circuit inverseur C-MOS comporte, dans ses deux branches de circuit, respectivement un circuit série de deux transistors (Tq, Tr; Ts, Tt) dont les transistors internes (Tr; Ts) sont reliés, par leurs électrodes de commande, à l'entrée (ej) du dispositif de couplage de signaux à large bande.

7. Dispositif de couplage de signaux à large bande suivant la revendication 6,
caractérisé en ce
qu'à l'inverseur C-MOS (Tp, Tn) est relié en aval un amplificateur différentiel (OP) monté en suiveur.
